# EUROPÄISCHE PATENTANMELDUNG

(11) **EP 0 702 399 A1**
(43) Veröffentlichungstag der Anmeldung: **20.03.1996**
(21) Anmeldenummer: 95114393.2
(22) Anmeldetag: 13.09.1995
(51) Int. Cl.: H01L 21/306

(54) **Verfahren zum nasschemischen Entfernen von Kontaminationen auf Halbleiterkristalloberflächen**

(30) Priorität: 14.09.1994 DE 4432738
(71) Anmelder: SIEMENS AKTIENGESELLSCHAFT, D-80333 München (DE)
(72) Erfinder: Lechner, Alfred, Dr., Prof., D-93138 Lappersdorf (DE); Müller, Erich, Dr. Dipl.-Phys., D-93161 Sinzing (DE); Rieger, Walter, Dr., Dipl.-Chem., D-93138 Lappersdorf (DE)

(57) **Zusammenfassung**

Als Reinigungsmedium wird nur noch hochreines deionisiertes Wasser verwendet, dem handelsübliche Metallkomplexbildner, beispielsweise Ethylendiamintetraacetat (EDTA), im ppm-Konzentrationsbereich zugesetzt sind. Die bisherige Bereitstellung höchstreiner und deshalb aufwendiger Chemikalien-Mischungen entfällt.

## Beschreibung

Die Erfindung betrifft ein Verfahren zum Entfernen von Kontaminationen auf Halbleiterkristalloberflächen.

Bei der Herstellung von hochintegrierten elektronischen Schaltungen müssen den einzelnen Technologieverfahren (Diffusion, Abscheidung, Ätzen, usw.) Reinigungsprozesse vor- bzw. nachgeschaltet werden, um beispielsweise qualitativ hochwertige Isolationsschichten zu erhalten. Auf der Oberfläche des normalerweise aus Silizium bestehenden Substrats können sich insbesondere aus verschiedenen Quellen stammende Verunreinigungen durch Schwermetalle und/oder Alkalimetalle anlagern. Weiter ist mit der Anlagerung von Partikelverunreinigungen und von organischen Kontaminationen zu rechnen.

Es ist bekannt, organische, metallische und partikuläre Kontaminationen mit Mischungen von höchstreinen Chemikalien von den Halbleiteroberflächen abzulösen. Dabei werden die Halbleiterscheiben entweder in geeignete chemische Bäder eingetaucht, häufig unter Ultraschalleinwirkung, oder die Reinigungsflüssigkeit wird in einem sogenannten Cleaner auf die Scheiben gesprüht. Zum Abtrag von metallischen Kontaminationen werden bisher Salz- bzw.Schwefelsäure/Wasserstoffperoxid-Mischungen eingesetzt, während zur Entfernung von Partikeln und organischen Resten Ammoniak/Wasserstoffperoxid- oder Cholin/Wasserstoffperoxid-Mischungen üblich sind. Damit dabei die Reinigungswirkung sichergestellt ist, werden an die Chemikalien vor ihrem Einsatz höchste Reinheitsanforderungen gestellt, die ihrerseits nur durch aufwendige und kostenträchtige Reinigungsverfahren gewährleistet werden können.

Der vorliegenden Erfindung liegt daher die Aufgabe zugrunde, ein Verfahren der eingangs angegebenen Art zu schaffen, das bei mindestens gleichbleibender Qualität weniger aufwendig als die bekannten Verfahren ist.

Diese Aufgabe wird erfindungsgemäß dadurch gelöst, daß als naßchemisches Reinigungsmedium hochreines deionisiertes Wasser verwendet wird, dem Metallkomplexbildner im ppm-Konzentrationsbereich zugesetzt werden.

Weiterbildungen der Erfindung sind Gegenstand von Unteransprüchen. Vorteile und Einzelheiten der Erfindung werden anhand des folgenden Ausführungsbeispiels noch näher erläutert.

Das erfindungsgemäße Verfahren ermöglicht es, daß metallische Kontaminationen als Komplexverbindungen effektiv von der Scheibenoberfläche abgelöst werden. Zur Unterstützung und Erweiterung des Reinigungsprozesses hinsichtlich partikulärer Verunreinigungen kann eine zusätzliche Ultraschalleinwirkung und/oder der Zusatz von oberflächenspannungsreduzierenden Substanzen, beispielsweise sind übliche Tenside geeignet, zum Reinigungsmedium vorgesehen werden. Ebenso kann die Reinigungswirkung durch Temperaturvariation im Bereich von etwa 0-110°C optimiert werden. Weiterhin können durch zusätzliche Ozonzudosierung organische Verbindungen, die durch Ozon verbrannt werden, beseitigt werden.

Der entscheidende Vorteil der Erfindung ergibt sich daraus, daß als mengenmäßig relevantes Reinigungsmedium nur noch hochreines (üblich ist 18,2 MOhm) deionisiertes Wasser verwendet wird, das ohne großen Aufwand herstellbar ist. Da deionisiertes Wasser bedeutend höhere Reinheitsgrade erreicht als höchstreine Chemikalien, liegt sogar eine Verbesserung der Reinigungswirkung im Rahmen der Erfindung. Da der Anteil der Metallkomplexbildner - und auch der der oberflächenspannungsreduzierenden Substanzen bzw. der des Ozons - nur im ppm-Konzentrationsbereich liegt, ist deren Verunreinigungsgrad im wesentlichen unbeachtlich, so daß normal im Handel erhältliche Substanzen verwendet werden können. Bei der Auswahl des bei einem pH von etwa 7 wasserlöslichen Metallkomplexbildners ist lediglich zu beachten, daß dieser eine hinreichend große Komplexbildungskapazität für Metalle während des gesamten Reinigungsprozesses aufweist, um beispielsweise eine Hydroxidausfällung auf Halbleiteroberflächen zu vermeiden. Abgelöste Komplexe und/oder überschüssige Komplexbildner dürfen ferner nicht auf Halbleiteroberflächen adsorbieren. Als geeigneter Komplexbildner hat sich beispielsweise Ethylendiamintetraacetat (EDTA) herausgestellt, das in einer Konzentration von etwa 0,7 ppm in der wässsrigen Lösung verwendet wird. Möglich ist auch die Verwendung komplexbildender Phosphorsäuren, wie sie beispielsweise unter der Bezeichnung DEQUEST (als Warenzeichen eingetragen) im Handel erhältlich sind. Das zur Entfernung organischer Kontaminationen empfehlenswerte Ozon kann über konventionelle Ozongeneratoren eingebracht werden.

Das erfindungsgemäße Verfahren bringt vielfältige Vorteile mit sich. Eine erhebliche Kostenreduzierung bei gegenüber gängigen Verfahren mindestens gleichbleibender Reinigungsgualität ergibt sich insbesondere durch die offensichtliche Minimierung des Chemikalienverbrauchs und durch den Entfall von zentralen Chemikalienversorgungssystemen, da der Komplexbildner dem hochreinen Wasser einfach mittels eines Dosimats zudosiert werden kann. Da auf Säuren, Laugen, etc. verzichtet wird, resultiert ein einfacher aufgebautes Reinigungseguipment und eine Minimierung der Chemikalienentsorgungskosten. Die bisherigen aufwendigen Qualitätskontrollen bezüglich des Reinheitsgrades der Chemikalien entfallen. Ferner ergibt sich ein erleichtertes Recycling des bisher zum Nachspülen nach dem eigentlichen Reinigungsprozeß eingesetzten deionisierten Wassers. Das erfindungsgemäße Verfahren ist auch umweltverträglicher als das bisher verwendete.

## Patentansprüche

1. Verfahren zum Entfernen von Kontaminationen auf Halbleiterkristalloberflächen,
**dadurch gekennzeichnet,**
daß als naßchemisches Reinigungsmedium hochreines deionisiertes Wasser verwendet wird, dem Metallkomplexbildner im ppm-Konzentrationsbereich zugesetzt werden.

2. Verfahren nach Anspruch 1,
**dadurch gekennzeichnet,**
daß die Reinigung unter zusätzlicher Ultraschalleinwirkung erfolgt.

3. Verfahren nach Anspruch 1 oder 2,
**dadurch gekennzeichnet,**
daß dem Reinigungsmedium zusätzlich oberflächenspannungsreduzierende Substanzen zugesetzt werden.

4. Verfahren nach einem der Ansprüche 1 bis 3,
**dadurch gekennzeichnet,**
daß die Reinigung unter zusätzlicher Ozonzudosierung erfolgt.

5. Verfahren nach einem der Ansprüche 1 bis 4,
**dadurch gekennzeichnet,**
daß als Metallkomplexbildner Ethylendiamintetraacetat (EDTA) verwendet wird.

6. Verfahren nach Anspruch 5,
**dadurch gekennzeichnet,**
daß der Metallkomplexbildner in einer Konzentration von etwa 0,7 ppm in der wässrigen Lösung verwendet wird.
